# EUROPEAN PATENT SPECIFICATION

(11) **EP 1 744 345 B1**
(45) Date of publication and mention of the grant of the patent: **15.06.2011**
(21) Application number: 05254638.9
(22) Date of filing: 26.07.2005
(51) Int. Cl.: H01J 37/32

(54) **Multi chamber plasma process system**
Mehrkammerplasmaprozesssystem
Système à plusieurs chambres de traitement par plasma

(30) Priority: 15.07.2005 KR 2005064191
(43) Date of publication of application: 17.01.2007
(73) Proprietor: GEN Co., Ltd., 486 Sindong, Yeongtong-gu, Suwon-Si 443-734 Gyeonggi-do (KR)
(72) Inventor: Wi, Soon-Im, 840-102, Byeokjeokgol Jugong Apt., Suwon-si Gyeonggi-do 443-725 (KR)
(74) Representative: Greene, Simon Kenneth

(56) References cited:
- EP-A1- 0 650 183
- WO-A2-2004/070743
- US-A1- 2002 121 345
- US-A1- 2003 196 757
- US-A1- 2003 227 259
- US-A1- 2004 149 218
- US-B1- 6 444 137

## Description

The present invention relates to a multi-chamber system and, more particularly, to a multi-chamber plasma process system, in which an inductively coupled plasma (ICP) process chamber has a multiple construction, thereby being capable of processing, in parallel, substrates to be processed, such as semiconductor substrates or liquid crystal glass substrates.

As well known, in a semiconductor industry for manufacturing semiconductor integrated circuitry or liquid crystal displays, a multi-chamber system is put to practical use to enhance productivity. The multi-chamber system has a structure where a number of process chambers are arranged either in a cluster type or around a substrate flow path that is formed by a conveyor or track. In the multi-chamber system, the process chambers are arranged horizontally or stacked in two or more numbers.

In the current semiconductor industry, the substrate to be processed shows a tendency toward increase in diameter, and the integrated circuit shows a tendency toward fine pattern, high precision, complication, etc. The resulting increase of complex processes as well as batch processing requests reduction of processes. In this respect, the multi-chamber system facilitates to cope with the complex processes and can improve productivity due to the reduction of processes caused by the batch processing.

In order to enhance productivity per unit area, the multi-chamber system is necessary to more effectively dispose each component and to integrate parts having a possibility to be integrated. In most multi-chamber systems, each of the process chambers may be inefficient because it has an individual power supply structure. Thus, the multi-chamber system needs to decrease areas of facilities and costs by means of effective integration in the power supply structure.

Meanwhile, a plasma process that is widely used in the semiconductor manufacturing process is very important to generate plasma and to properly maintain a density of the plasma according to a process characteristic. In order to effectively integrate the power supply structure, the multi-chamber system having plasma process chambers employing an inductively coupled plasma technique must be designed making sufficient allowance for supply of ignition power, supply of high-frequency power, matching of impedances and so on. Further, the plasma density of each process chamber must be adjusted according to the process characteristic.

US 2002/0121345 describes a multi-chamber plasma deposition system. An inductive core arrangement is used.

WO 2004/070743 describes a transformer ignition circuit for a transformer coupled plasma source.

US 2003/0196757 describes a first and second matching network for coupling respective RF sources to a plasma chamber.

In accordance with an aspect of the invention, the present invention provides a multi-chamber plasma process system according to claim 1.

Preferably, the inductively coupled plasma generators provided to the plurality of process chambers may be electrically connected in series to the main power supply through the first impedance matcher. The ignition electrodes provided to the inductively coupled plasma generators may be connected in parallel to the ignition power supply.

Preferably, the plurality of process chambers may have a stacked structure stacked by at least two process chambers or a cluster structure.

Preferably, the first impedance matcher and the plurality of second impedance matchers may each include at least one variable inductor for impedance matching. The variable inductor may include first and second magnetic cores that take a horseshoe shape and have both ends disposed opposite to each other, first and second winding coils wound around the first and second magnetic cores respectively, and a driving means moving the first and/or second magnetic cores based on control of the controller to vary a relative position between the first and second magnetic cores. In the variable inductor, as the relative position between the first and second magnetic cores is varied, magnetic flux induced by the first and second winding coils may have an aligned or deflected direction or an inverse direction, and thereby inductance caused by the first and second winding coils may be varied. Further, as the relative distance between the first and second magnetic cores is varied, the magnetic flux induced by the first and second winding coils may cause the number of magnetic flux concentrated to the first and second magnetic cores to be increased or decreased, and thereby the inductance caused by the first and second winding coils may be varied.

Preferably, the first impedance matcher and the plurality of second impedance matchers may each include at least one variable inductor for impedance matching. The variable inductor may include first and second hollow tubes that have both ends opened and disposed in parallel, first and second continuous winding coils wound around the first and second magnetic cores respectively, first and second magnetic cores that are mounted to the first and second hollow tubes, take a horseshoe shape and have both ends disposed opposite to each other, and a driving means moving the first and/or second magnetic cores based on control of the controller to vary a relative distance between the first and second magnetic cores. In the variable inductor, as the relative distance between the first and second magnetic cores is varied, the magnetic flux induced by the first and second winding coils may cause the number of magnetic flux concentrated to the first and second magnetic cores to be increased or decreased, and thereby inductance caused by the first and second winding coils may be varied. The first and second hollow tubes may be formed of an insulator

Preferably, the ignition power supply may include a variable transformer that is connected to the power supply on a primary side thereof and that is connected in parallel to the ignition electrodes of the inductively coupled plasma generators on a secondary side. The variable transformer may include first and second magnetic cores that take a horseshoe shape and have both ends disposed opposite to each other, a first winding coil wound around the first magnetic core; a second winding coil wound around the second magnetic core, and a driving means moving the first and/or second magnetic cores based on control of the controller to vary a relative position between the first and second magnetic cores. In the variable transformer, as the relative position between the first and second magnetic cores is varied, magnetic flux induced by the first and second winding coils may have an aligned or deflected direction or an inverse direction, and thereby inductance caused by the first and second winding coils may be varied. Further, as the relative distance between the first and second magnetic cores is varied, the magnetic flux induced by the first and second winding coils may cause the number of magnetic flux concentrated in common to the first and second magnetic cores to be increased or decreased, and thereby induced electromotive force transmitted from the primary winding coil to the secondary winding coil may be varied.

Preferably, the plurality of process chambers each have at least two holes on a ceiling of a chamber housing in which a susceptor is disposed, the susceptor having a subtracted to be processed rested thereon. The inductively coupled plasma generator may include at least one external discharge bridge of a hollow C shape having one side coupled to the at least two holes, at least one donut-like magnetic core mounted to the external discharge bridge, and an induction coil wound around the magnetic core and connected to the main power supply through the first impedance matcher. The induction coil may induce electromotive force to form a plasma discharge path inside the external discharge bridge and inside the chamber housing. The external discharge bridge and the chamber housing may have an insulator layer formed on inner surfaces thereof on the whole.

Preferably, the inductively coupled plasma generator may include a plasma density regulator. The plasma density regulator may include a density regulation flat plate mounted across an inner upper discharge space of the external discharge bridge and formed with holes on the whole; and a driving means moving the density regulation flat plate up and down. Thereby, the plasma may be increased in density as the density regulation flat plate moves upward, while the plasma may be decreased in density as the density regulation flat plate moves downward.

Preferably, the plurality of process chambers may each have a plurality of holes on a ceiling of a chamber housing in which a susceptor is disposed. The susceptor may have a subtracted to be processed rested thereon. The inductively coupled plasma generator may include: a hollow discharge tube head having a plurality of holes on a lower surface thereof to correspond to the plurality of holes formed on the ceiling of the chamber housing and having a gas inlet on an upper surface thereof; a plurality of hollow discharge tube bridges each connected between the plurality of holes formed on the ceiling of the chamber housing and the plurality of holes formed on the lower surface of the hollow discharge tube head and corresponding to the plurality of holes formed on the ceiling; a donut-like magnetic core mounted to the hollow discharge tube bridges; and an induction coil wound around the magnet core and connected to the main power supply through the first impedance matcher. Here, the induction coil induces electromotive force to form a plasma discharge path connecting insides of the hollow discharge tube head, the plurality of hollow discharge bridges and the chamber housing. The magnetic core may be not mounted to at least one of the plurality of hollow discharge bridges. The hollow discharge tube head, the plurality of hollow discharge bridges and the chamber housing may have an insulator layer formed on inner surfaces thereof on the whole.

Preferably, the inductively coupled plasma generator may include a plasma density regulator. The plasma density regulator may include a density regulation flat plate mounted across an inner discharge space of the hollow discharge tube head and formed with holes on the whole; and a driving means moving the density regulation flat plate up and down. Here, the plasma may be increased in density as the density regulation flat plate moves upward, while the plasma may be decreased in density as the density regulation flat plate moves downward.

Preferably, the plurality of process chambers may each have an inductively coupled plasma generator disposed in an inner upper space of a chamber housing in which a susceptor is disposed. The inductively coupled plasma generator may include an annular hollow core jacket positioned on the upper space of the chamber housing, at least one fixing bridge extending from an upper sidewall of the chamber housing to the hollow core jacket so as to fix the hollow core jacket in the upper space of the chamber housing, annular magnetic core 945 mounted in the hollow core jacket, and an induction coil wounded around the annular magnetic core. Here, the induction coil may induce electromotive force to form a plasma discharge path surrounding outside of the hollow core jacket on the whole. The hollow core jacket and the fixing bridge may be formed of an insulator, and the chamber housing may have an insulator layer formed on an inner surface thereof on the whole.

Preferably, the inductively coupled plasma generator may include a plasma density regulator. The plasma density regulator may include a density regulation flat plate mounted across an inner upper space of the chamber housing over the hollow core jacket on the whole; and a driving means moving the density regulation flat plate up and down. Here, the plasma may be increased in density as the density regulation flat plate moves upward, while the plasma may be decreased in density as the density regulation flat plate moves downward.

Therefore, the present invention is directed to provide a multi-chamber plasma process system, in which a multi-chamber system having inductively coupled plasma process chambers effectively integrates power supply systems including ignition power sources, radio-frequency power sources, impedance matchers etc. to thus decrease areas of facilities and costs of the multi-chamber system and improve a process yield by individually controlling a density of plasma of each process chamber, thereby being capable of improving productivity of the multi-chamber system on the whole.

The above and other features and advantages of the present invention will become more apparent to those of ordinary skill in the art by describing in detail preferred embodiments thereof with reference to the attached drawings in which:
Fig. 1 is a circuit diagram showing an entire configuration of a multi-chamber plasma process system of the present invention;
Fig. 2 shows an example where process chambers are formed in a stacked structure in a multi-chamber plasma process system of the present invention;
Fig. 3 is a perspective view showing a structure of the variable inductors constituting the first impedance matcher of Fig. 1;
Figs. 4a to 4c show examples where a relative position between the first and second magnetic cores is varied;
Fig. 5 is a perspective view showing another structure of the variable inductors constituting the first impedance matcher of Fig. 1;
Fig. 6 is a perspective view showing a structure of the variable transformer constituting the ignition power supply of Fig. 1;
Figs. 7a to 7c are views for explaining a variable control mode of the variable transformer of Fig. 6;
Figs. 8 and 9 are perspective and cross-sectional views showing one example of process chambers employed to a multi-chamber plasma process system of the present invention, respectively;

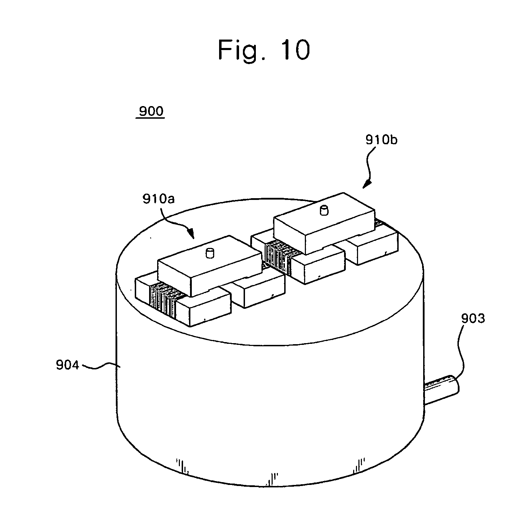

Fig. 10 is a perspective view showing a modification of the process chamber shown in Fig. 8;
Figs.11 and 12 are perspective and cross-sectional views showing another example of process chambers employed to a multi-chamber plasma process system of the present invention, respectively;
Figs. 13 and 14 are perspective and cross-sectional views showing yet another example of process chambers employed to a multi-chamber plasma process system of the present invention, respectively;
Fig. 15 is a circuit diagram of a multi-chamber plasma process system having a function of regulating a density of plasma; and
Figs. 16, 17 and 18 are cross-sectional views showing examples where plasma density regulators are provided to process chambers employed to a multi-chamber process system of the present invention, respectively.

Hereinafter, a multi-chamber plasma process system of the present invention will be described in detail with reference to the attached drawings, in which exemplary embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout the specification.

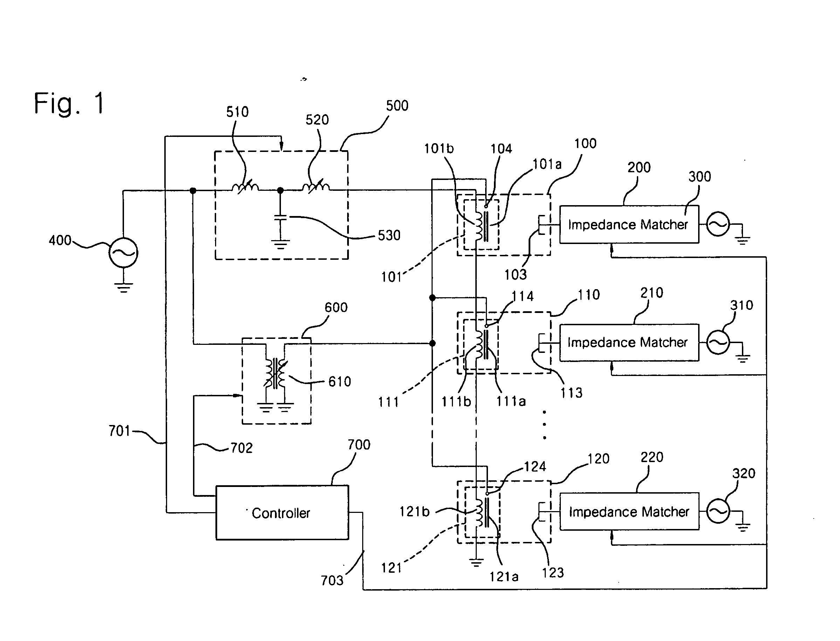

Fig. 1 is a circuit diagram showing an entire configuration of a multi-chamber plasma process system of the present invention.

The multi-chamber plasma process system has a plurality of process chambers 100, 110 and 120. The plurality of process chambers 100, 110 and 120 are provided with inductively coupled plasma generators 101, 111 and 121, respectively. The inductively coupled plasma generators 101, 111 and 121 include magnetic cores 101 a, 111 a and 121 a and winding coils 101 b, 111 b and 121 b wound around the magnetic cores, respectively. The inductively coupled plasma generators 101, 111 and 121 are electrically connected in series and to a main power supply 400 through a first impedance matcher 500.

The main power supply 400 supplies RF (Radio Frequency) power to the inductively coupled plasma generators 101, 111 and 121 through the first impedance matcher 500. The main power supply 400 supplies the RF power to an ignition power supply 600. The ignition power supply 600 is supplied with the RF power from the main power supply 400, thus supplying ignition power to ignition electrodes 104, 114 and 124 that are mounted to the inductively coupled plasma generators 101, 111 and 121 respectively.

The plurality of process chambers 100, 110 and 120 has susceptors 103, 113 and 123, respectively. The susceptors 103, 113 and 123 are connected to bias power sources 300, 310 and 320 through second impedance matchers 200, 210 and 220, respectively.

The first impedance matcher 500, the second impedance matchers 200, 210 and 220, and the ignition power supply 600 are controlled by a controller 700. For the purpose of impedance matching, the controller 700 outputs a first control signal 701 for controlling the first impedance matcher 500, a second control signal 702 for controlling the ignition power supply 600, and a third control signal 703 for controlling the second impedance matchers 200, 210 and 220.

The first impedance matcher 500 includes first and second variable inductors 510 and 520 that are connected in series between input and output terminals, and a capacitor 530 that is connected between a connection node of the first and second variable inductors 510 and 520 and a ground. The first and second variable inductors 510 and 520 have an inductance value varied depending on the first control signal 701 of the controller 700. The first and second variable inductors 510 and 520 will be described below in detail.

The ignition power supply 600 is composed of a variable transformer 610, a primary side of which is connected to the main power supply 400, and a secondary side is connected in parallel to the ignition electrodes 104, 114 and 124 of the inductively coupled plasma generators 101, 111 and 121. The variable transformer 610 has a secondary side inductive voltage varied depending on the second control signal 702 of the controller 700. Although being described below in detail, the controller 700 causes the ignition power supply 600 not only to supply ignition power in a plasma igniting step of the inductively coupled plasma generators 101, 111 and 121, but also not to supply the ignition power after plasma discharge occurs, thereby performing an interruption function of operating the variable transformer 610.

The second impedance matchers 200, 210 and 220 may have the same configuration as the above-mentioned first impedance matcher 500. The second impedance matchers 200, 210 and 220 perform operation for the impedance matching on the basis of the third control signal 703 of the controller 700.

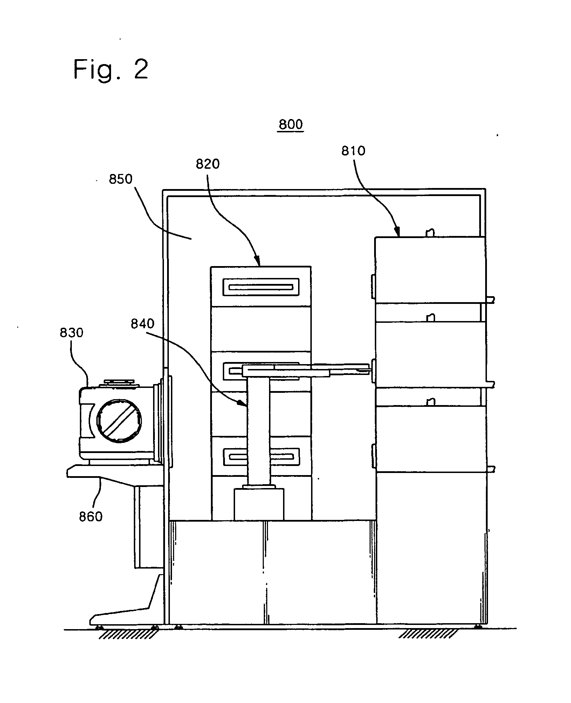

Fig. 2 shows an example where process chambers are formed in a stacked structure in a multi-chamber plasma process system of the present invention.

As shown in Fig. 2, the multi-chamber plasma process system 800 may be constructed to have a structure where two or more process chambers 810 are vertically stacked in a transfer chamber 850. The stacked process chambers 810 is provided in the front thereof with a transfer robot 840 that can vertically move up and down and, on one side of which one or more cooling or heating stage 820 is stacked.

In this manner, the multi-chamber plasma process system may be constructed either by stacking two or more process chambers, or by disposing a plurality of process chambers in a cluster structure. And, even if not described in detail, the plurality of process chambers may be variously disposed using a transfer system such as a track or conveyor system.

The multi-chamber plasma process system of the present invention is adapted not only to have an intensive disposition structure in the stacked or cluster structure type, but also to effectively integrate the power supply systems including the ignition power sources, RF power sources, impedance matchers and so on, thereby being capable of improving productivity as well as decreasing areas of facilities and costs effectively.

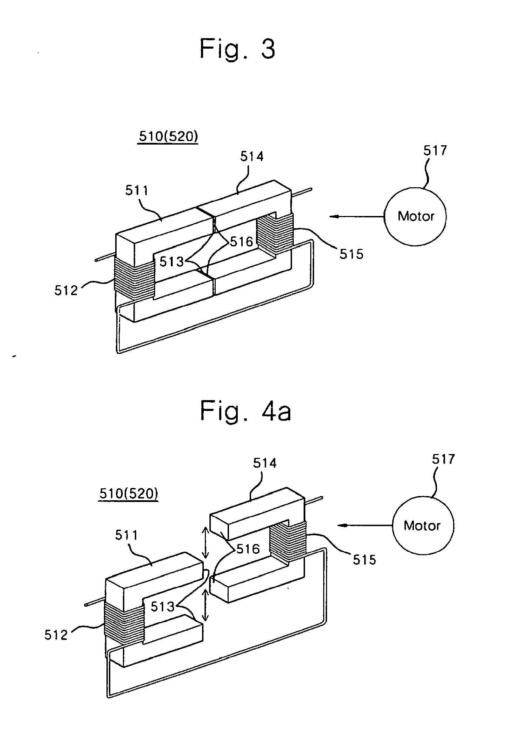

Fig. 3 is a perspective view showing a structure of the variable inductors constituting the first impedance matcher of Fig. 1.

Referring to Fig. 3, the variable inductors 510 and 520 constituting the first impedance matcher 500 have a structure suitable for RF high power. Each of the variable inductors 510 and 520 has first and second magnetic cores 511 and 514 that take a horseshoe shape and have both ends disposed to be opposite to each other. The first and second magnetic cores 511 and 514 are wound with first and second winding coils 512 and 515, respectively. The first and second winding coils 512 and 515 are formed of a continuous winding.

Each of the variable inductors 510 and 520 has a driving means 517 for varying a relative position between the first and second magnetic cores 511 and 514 to vary inductance caused by the first and second winding coils 512 and 515. The driving means 517 may be configured of, for example, an electric motor. The driving means 517 is controlled by the first control signal 701 of the controller 700.

Figs. 4a to 4c attached herein show examples where the relative position between the first and second magnetic cores 511 and 514 is varied by the driving means 517, and thereby varying the inductance of the variable inductors 510 and 520.

As shown in Fig. 4a, the first and second magnetic cores 511 and 514 are displaced in a vertical (or horizontal) direction by the driving means 517 so that magnetic flux input and output parts 513 and 516 are aligned or deflected. In this case, according to a deflected degree, each of the variable inductors 510 and 520 is subjected to variation of the inductance.

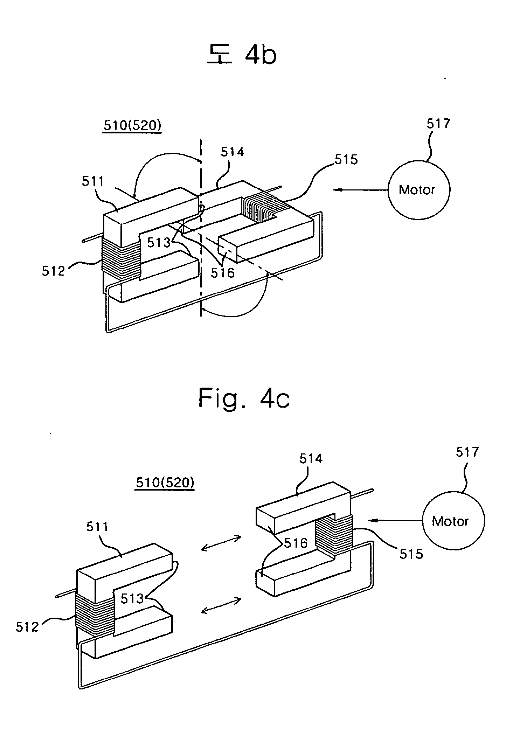

As another example, as shown in Fig. 4b, the first and second magnetic cores 511 and 514 are rotated by the driving means 517 so that the magnetic flux input and output parts 513 and 516 are aligned or crossed or have an inverse direction. In this case, according to a rotational angle, each of the variable inductors 510 and 520 is varied in inductance.

As set forth above, as the relative position between the first and second magnetic cores 511 and 514 (the vertically or horizontally deflected degree or crossed rotational angle) is varied, the magnetic flux induced by the first and second winding coils 512 and 515 has an aligned or deflected direction or an inverse direction. Thereby, each of the variable inductors 510 and 520 is varied in inductance by the first and second winding coils.

As yet another example, as shown in Fig. 4c, the first and second magnetic cores 511 and 514 are displaced by the driving means 517 so that a relative distance between the magnetic flux input and output parts 513 and 516 is near or distant. In this case, according to the relative distance, each of the variable inductor 510 and 520 is varied in the inductance. To be more specific, in the variable inductors 510 and 520, as a relative distance between the first and second magnetic cores 511 and 514 is varied, the magnetic flux induced by the first and second winding coils 512 and 515 causes the number of the magnetic flux concentrated to the first and second magnetic cores 511 and 514 to be increased or decreased. Thereby, the inductance by the first and second winding coils 512 and 515 is varied.

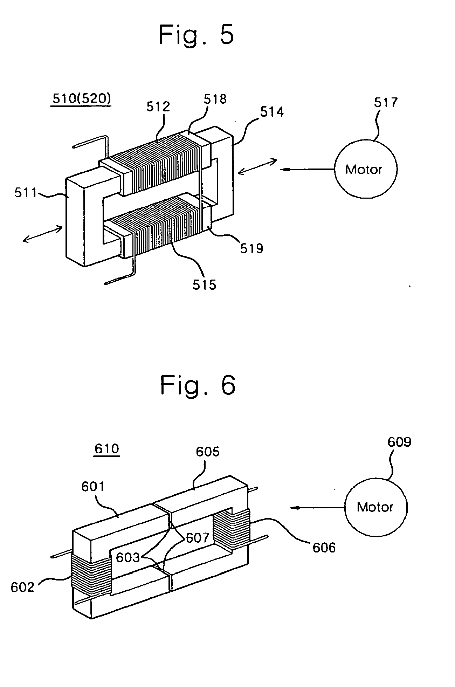

Referring to Fig. 5, each of the variable inductor 510 and 520 has first and second hollow tube 518 and 519 which have both ends opened and are arranged in parallel. The first and second hollow tubes 518 and 519 are wound with first and second winding coils 512 and 515, respectively. The first and second winding coils 512 and 515 are formed of a continuous winding. The first and second hollow tube 518 and 519 are mounted therein with first and second magnetic cores 511 and 514, respectively, wherein the first and second magnetic cores 511 and 514 take a horseshoe shape and are opposite to each other. Each of the variable inductor 510 and 520 includes, for example, a driving means 517, which is used for displacing the first and/or second magnetic cores 511 and/or 514 on the basis of control of the controller 700 to thus vary a relative distance between the first and second magnetic cores.

In the variable inductors 510 and 520, as a relative distance between the first and second magnetic cores 511 and 514 is varied, the magnetic flux induced by the first and second winding coils 512 and 515 causes the number of the magnetic flux concentrated to the first and second magnetic cores 511 and 514 to be increased or decreased. Thereby, the inductance caused by the first and second winding coils 512 and 515 is varied.

The above-mentioned variable inductors 510 and 520 may be similarly constructed in the plurality of second impedance matchers 200, 210 and 220. The variable inductors installed to the plurality of second impedance matchers 200, 210 and 220 perform control operation for impedance matching on the basis of the third control signal 703 of the controller 700.

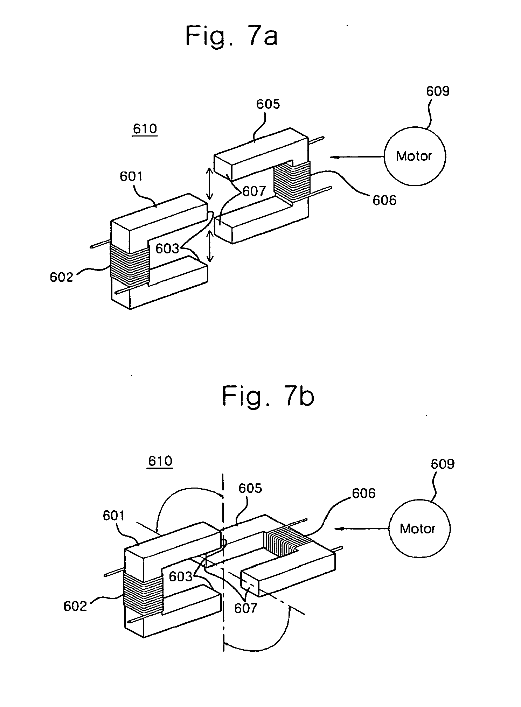

Fig. 6 is a perspective view showing a structure of the variable transformer constituting the ignition power supply of Fig. 1, and Figs. 7a to 7c are views for explaining a variable control mode of the variable transformer of Fig. 6.

Referring to Fig. 6, the variable transformer 610 constituting the ignition power supply 600 has a primary side connected to the main power supply 400, and a secondary side connected in parallel to the ignition electrodes 104, 114 and 124 of the inductively coupled plasma generators 101, 111 and 121.

The variable transformer 610 includes first and second magnetic cores 601 and 605, which take a horseshoe shape and have both ends disposed to face each other. The first and second magnetic cores 601 and 605 are wound with primary and secondary side winding coils 602 and 606, respectively. Here, the primary and secondary side winding coils 602 and 606 around which the first and second magnetic cores 601 and 605 wound are not continuous windings.

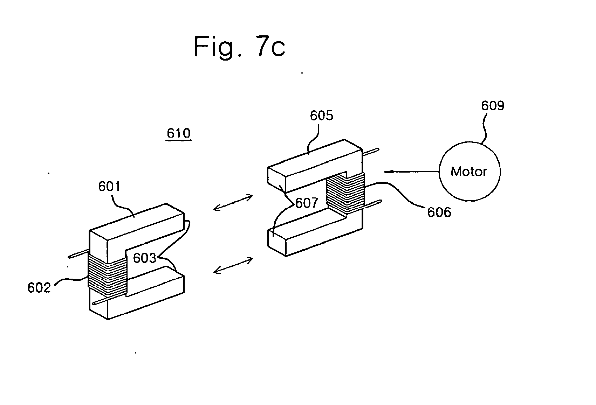

The variable transformer 610 includes, for example, a driving means 609 such as an electric motor. The driving means 609 displaces the first and/or second magnetic cores 601 and/or 605 on the basis of the second control signal 702 of the controller 700, thereby varying a relative position between the first and second magnetic cores. For example, a vertically or horizontally deflected degree (Fig. 7a), a crossed rotational angle (Fig. 7b) or a relative distance (Fig. 7c) is varied. With this configuration, the number of magnetic flux that is commonly concentrated to the first and second magnetic cores 601 and 605 is increased or decreased, so that induced electromotive force transmitted from the primary side winding coil 602 to the secondary side winding coil 606 is varied.

The ignition power supply 600 including the variable transformer 610 is controlled by the controller 700, thereby supplying the ignition electrodes 104, 114 and 124 of the inductively coupled plasma generators 101, 111 and 121 with RF high power for plasma ignition. And, after plasma discharge occurs, the variable transformer 610 operates according to control of the controller 700, and thereby the power for plasma ignition is no longer supplied.

As set forth above, the process chambers 100, 110 and 120 constituting the multi-chamber plasma process system of the present invention have the inductively coupled plasma generators 101, 111 and 121, respectively. However, their structures may be variously implemented as described below.

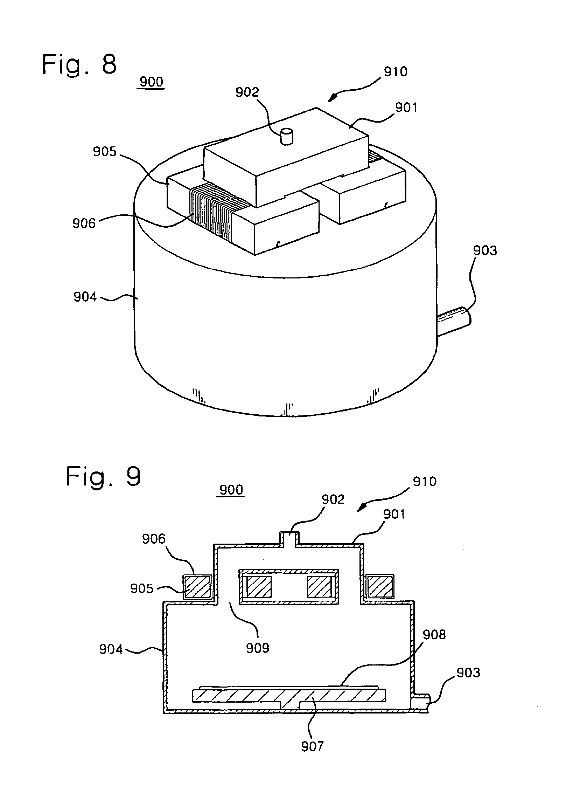

Figs. 8 and 9 are perspective and cross-sectional views showing one example of process chambers employed to a multi-chamber plasma process system of the present invention, respectively.

Referring to Figs. 8 and 9, a process chamber 900 according to one example employed to a multi-chamber plasma process system of the present invention is composed of two or more holes 909a and 909b on the ceiling of a chamber housing 904 in which a susceptor 907 is housed, wherein the susceptor 907 has a substrate 908 to be processed rested thereon. The two holes 909a and 909b are coupled with an inductively coupled plasma generator 910.

The inductively coupled plasma generator 910 has at least one external discharge bridge 901 of a hollow C shape, one side of which is coupled to the two holes 909a and 909b. The external discharge bridge 901 is mounted with one or more donut-like magnetic core 905 around which an induction coil 906 is wound, wherein the coil 906 is connected to the main power supply 400 through the first impedance matcher 500 (Fig. 1). The external discharge bridge 901 is provided with a gas inlet 902 at the upper center thereof, and the chamber housing 904 is provided with a gas outlet 903 on the lower portion thereof.

In the process chamber 900 as constructed in this manner, electromotive force is induced by the induction coil 906, thereby forming a plasma discharge path in the interiors of the external discharge bridge 901 and the chamber housing 904. The process chamber 900 may have an insulator layer (not shown), for example of quartz, that is formed on the inner surfaces of the external discharge bridge 901 and the chamber housing 904 in order to prevent polymerization.

In order to process a large area of substrate to be processed, the process chamber 900 may be provided with two or more inductively coupled plasma generators 910a and 910b on the ceiling of the chamber housing 904. Due to installation of the two or more inductively coupled plasma generators 910a and 910b, it is possible to generate plasma having much wider volume and improved uniformity.

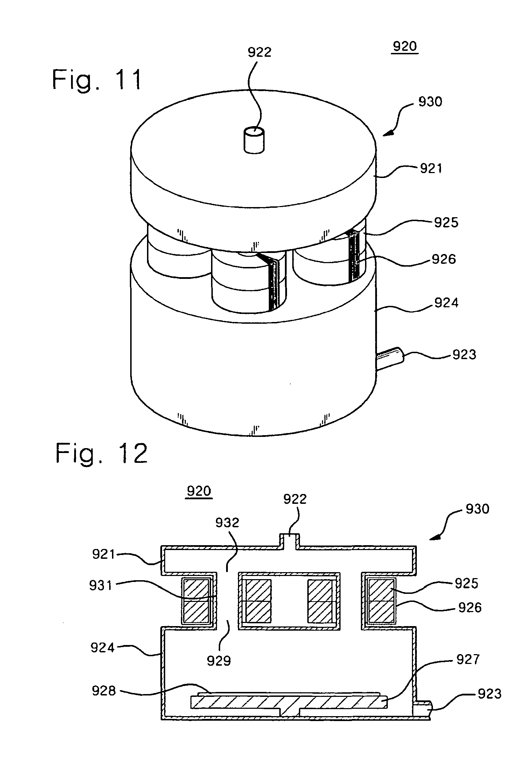

Figs. 11 and 12 are perspective and cross-sectional views showing another example of process chambers employed to a multi-chamber plasma process system of the present invention, respectively.

Referring to Figs. 11 and 12, a process chamber 920 according to another example employed to a multi-chamber plasma process system of the present invention has a plurality of holes 929 on the ceiling of a chamber housing 924 in which a susceptor 927 is housed, wherein the susceptor 927 has a workpiece 928 to be processed rested thereon. The plurality of holes 929 are coupled with an inductively coupled plasma generator 930.

The inductively coupled plasma generator 930 includes a hollow discharge tube head 921 and a plurality of hollow discharge tube bridges 931. The hollow discharge tube head 921 is provided on the lower surface thereof with a plurality of holes 931 that corresponding to the plurality of holes 929 formed on the ceiling of the chamber housing 924, and with a gas inlet 922 on the upper surface thereof. The plurality of hollow discharge tube bridges 931 are each connected between the plurality of holes 929 formed on the ceiling of the chamber housing 924 and the plurality of holes 932 formed on the lower surface of the hollow discharge tube head 921 and corresponding to the plurality of holes 929. In this embodiment, four hollow discharge tube bridges 931 are disposed in a tetragonal shape. To this end, the ceiling of the chamber housing 924 is formed with four holes 929, and the lower surface of the hollow discharge tube head 921 is formed with four holes 932.

And, each of the hollow discharge tube bridges 931 is mounted by a magnetic core of a donut shape, wherein the magnetic core 925 is wound with an induction coil 926 that is connected to the main power supply 400 through the first impedance matcher 500 (see Fig. 1).

In this process chamber 920, electromotive force is induced by the induction coil 926, thereby forming a plasma discharge path that connects the insides of the hollow discharge tube head 921, the plurality of hollow discharge tube bridges 931 and the chamber housing 924. Here, all of the hollow discharge tube bridges 931 may be mounted with the magnetic core 925 around which the induction coil 926 is wound.

Further, the magnetic core may not be mounted to at least one of the of the hollow discharge tube bridges 931. However, the plasma discharge path is still formed inside the hollow discharge tube bridge to which the magnetic core and the induction coil are not mounted. Furthermore, in order to process the large area of substrate to be processed, the number of hollow discharge tube bridges 931 may be increased.

As in the above-mentioned example, in order to prevent polymerization, the process chamber 920 may have an insulator layer (not shown), for example of quartz, that is formed on the inner surfaces of the hollow discharge tube head 921, the hollow discharge tube bridges 931 and the chamber housing 924 on the whole.

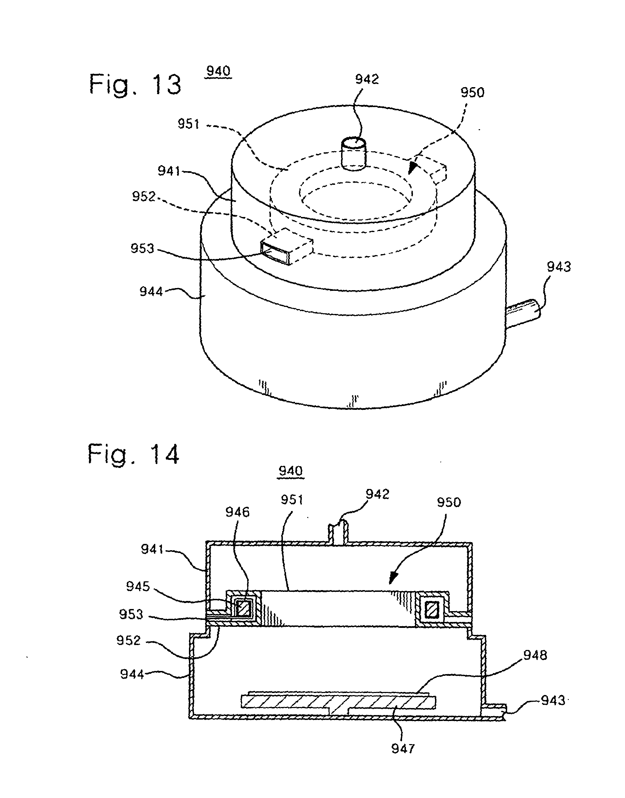

Figs. 13 and 14 are perspective and cross-sectional views showing yet another example of process chambers employed to a multi-chamber plasma process system of the present invention, respectively.

Referring to Figs. 13 and 14, a process chamber 940 according to yet another example employed to a multi-chamber plasma process system of the present invention is provided with an inductively coupled plasma generator 950 in the inner upper space of a chamber housing 944 in which a susceptor 947 is housed, wherein the susceptor 927 has a workpiece 948 to be processed rested thereon.

The inductively coupled plasma generator 950 includes an annular hollow core jacket 951 that is disposed in the inner upper space of the chamber housing 944. The hollow core jacket 951 has at least one fixing bridge 952 that extends from an upper sidewall 941 of the chamber housing 944 so as to be fixed in the upper space of the chamber housing 944. The hollow core jacket 951 is mounted therein with annular magnetic core 945 and induction coil 946 wounded around the annular magnetic core 945.

In this process chamber 940, electromotive force is induced by the induction coil 946, thereby forming a plasma discharge path that surrounds outside the hollow core jacket 951 on the whole. Further, in order to process the large area of substrate to be processed, the hollow core jacket 951 may be increased in size, and thus the magnetic core 945 may also be increased in size so as to be suitable for the size of the hollow core jacket 951. In addition, the hollow core jacket 951 and the magnetic core 945 may be increased in number.

As in the above-mentioned examples, in the process chamber 940, in order to prevent polymerization, the hollow core jacket 950 and the fixing bridge 952 may be formed of an insulator such as quartz, and the inner surface of the chamber housing 924 may be also covered with an insulator layer.

As set forth above, the multi-chamber plasma process system of the present invention may include various inductively coupled plasma generators in the plurality of process chambers as in the above-mentioned examples. Further, as set forth below, the plurality of process chambers may each include a regulator for regulating a density of plasma.

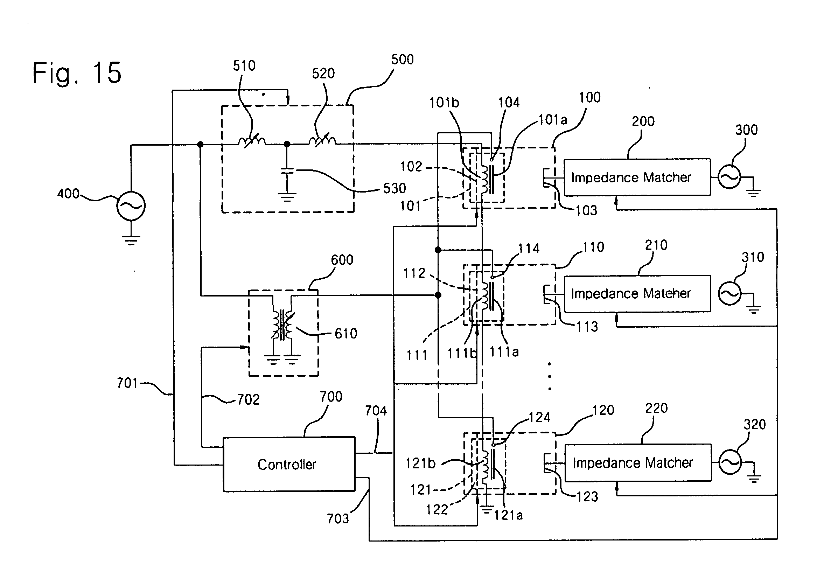

Fig. 15 is a circuit diagram of a multi-chamber plasma process system having a function of regulating a density of plasma.

Referring to Fig. 15, an entire configuration of a multi-chamber plasma process system having a function of regulating a density of plasma is basically constructed similar to that shown in Fig. 1. However, a plurality of process chambers 100, 110 and 120 are provided with plasma density regulators 102, 112 and 122 for regulating a density of plasma generated by the inductively coupled plasma generators 101, 111 and 121, respectively. The plasma density regulators 102, 112 and 122 are controlled by a third control signal 704 supplied from a controller 700.

As mentioned below, each of the plasma density regulators is configured of a density regulation flat plate and a driving means for driving the density regulation flat plate. The driving means drives the density regulation flat plate based on the third control signal 704 of the controller 700.

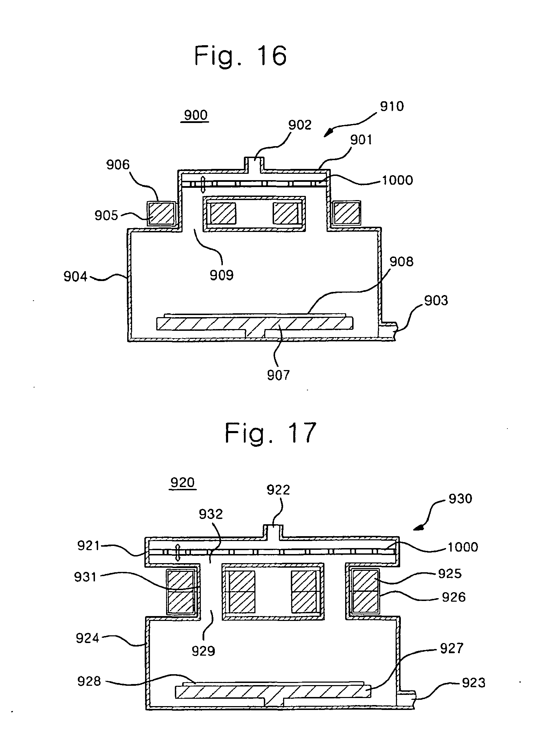

Figs. 16 to 18 are cross-sectional views showing examples where plasma density regulators are provided to process chambers employed to a multi-chamber process system of the present invention, respectively.

As shown in Fig. 16, a process chamber 900 of one embodiment has a density regulation flat plate 1000 mounted across the inner upper discharge space of an external discharge bridge 901 on the whole, wherein the density regulation flat plate 1000 is formed with holes. The density regulation flat plate 1000 moves up and down by means of a driving means (not shown). The driving means may be variously configured, for example a hydraulic or pneumatic value or an electric motor and gear assembly.

As shown in Fig. 17, a process chamber 920 of another embodiment has a density regulation flat plate 1000 mounted across the inner upper space of a hollow discharge tube head 921 on the whole. The density regulation flat plate 1000 moves up and down by means of a driving means (not shown) as set forth above.

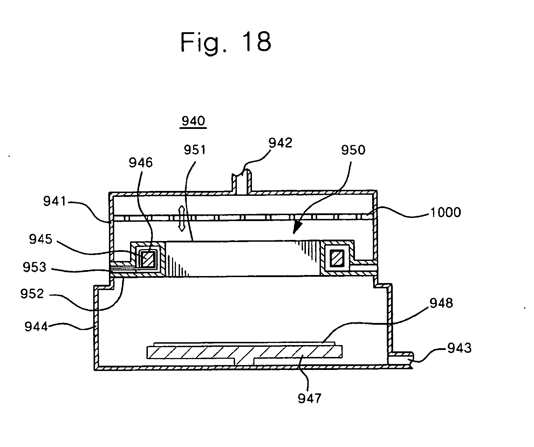

As shown in Fig. 18, a process chamber 940 of yet another embodiment has a density regulation flat plate 1000 mounted across the inner upper space of a chamber housing over a hollow core jacket 951 on the whole. The density regulation flat plate 1000 moves up and down by means of a driving means (not shown) as set forth above.

As discussed above, in the case of the process chambers 900, 920 and 940, as the density regulation flat plate 1000 moves upward, a plasma discharge space is increased and thus the plasma density is increased. In contrast, as the density regulation flat plate 1000 moves downward, the plasma discharge space is decreased and thus the plasma density is decreased. As such, it is possible to improve a process yield by properly controlling the plasma density on the basis of process conditions or characteristics of each process chamber.

The above-mentioned multi-chamber plasma process system of the present invention is applied to various manufacturing processes, such as an ashing process, an etching process, a chemical vapor deposition process etc., for manufacturing semiconductor devices or liquid crystal display devices, thereby being capable of improving the process yield.

According to the above-mentioned multi-chamber plasma process system of the present invention, the power supply systems including the ignition power source, the RF power source, the impedance matcher and so on can be effectively integrated. Thereby, it is possible to decrease the areas of facilities and costs of the multi-chamber plasma process system, and to individually control the plasma density of each process chamber. Accordingly, the process yield is improved, and thereby the multi-chamber plasma process system can be further improved in productivity on the whole.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A multi-chamber plasma process system comprising:
a plurality of process chambers (100, 110, 120) each having an inductively coupled plasma generator (101, 111, 121);
a main power supply (400) arranged to supply radio frequency (RF) power for generating plasma to at last one of said inductively coupled plasma generators;
a first impedance matcher (500) connected between the main power supply and the at least one inductively coupled plasma generator;
a plurality of bias power sources (320) arranged to supply bias power to a susceptor (103, 113, 123) provided to each of the plurality of process chambers;
**characterised by** an ignition power supply (600) supplied with the RF power from the main power supply and arranged to supply ignition power to an ignition electrode (104, 114, 124) provided to each inductively coupled plasma generator (101, 111, 121);
a plurality of second impedance matchers (200, 210, 220) connected between the susceptors (103, 113, 123) provided to the plurality of process chambers and the bias power sources corresponding to the susceptors; and
a controller (700) arranged to control the first impedance, matcher, the plurality of second impedance matchers and the ignition power supply;
wherein the main power supply is arranged to supply radio frequency power for generating plasma to each of the inductively coupled plasma generators in the plurality of process chambers through the first impedance matcher.

2. The multi-chamber plasma process system according to claim 1, wherein the inductively coupled plasma generators (101, 111, 121) provided to the plurality of process chambers are electrically connected in series to the main power supply through the first impedance matcher (500), and the ignition electrodes (104, 114, 124) provided to the inductively coupled plasma generators are connected in parallel to the ignition power supply.

3. The multi-chamber plasma process system according to claim 1 or 2, wherein the plurality of process chambers (100, 110, 120) have a stacked structure stacked by at least two process chambers or a cluster structure.

4. The multi-chamber plasma process system according to any preceding claim, wherein
the first impedance matcher (500) and the plurality of second impedance matchers (200, 210, 220) each include at least one variable inductor for impedance matching;
the variable inductor includes first and second magnetic cores (511, 514) that take a horseshoe shape and have both ends disposed opposite to each other, first and second winding coils (512, 515) wound around the first and second magnetic cores respectively, and a driving means (517) arranged to move the first and/or second magnetic cores based on control of the controller to vary a relative position between the first and second magnetic cores; and
in the variable inductor, as the relative position between the first and second magnetic cores (511, 514) is varied, magnetic flux induced by the first and second winding coils has an aligned or deflected direction or an inverse direction and thereby inductance caused by the first and second winding coils is varied; or as the relative distance between the first and second magnetic cores is varied, the magnetic flux induced by the first and second winding coils causes the number of magnetic flux concentrated to the first and second magnetic cores to be increased or decreased and thereby the inductance caused by the first and second winding coils is varied.

5. The multi-chamber plasma process system according to any of claims 1 to 3, wherein
the first impedance matcher (500) and the plurality of second impedance matchers (200, 210, 220) each include at least one variable inductor for impedance matching;
the variable inductor includes first and second hallow tubes (518, 519) that have both ends opened and disposed in parallel, first and second continuous winding coils wound around the first and second magnetic cores (511, 514) respectively, first and second magnetic cores that are mounted to the first and second hollow tubes, take a horseshoe shape and have both ends disposed opposite to each other, and a driving means (517) arranged to move the first and/or second magnetic cores based on control of the controller to vary a relative distance between the first and second magnetic cores; and
in the variable inductor, as the relative distance between the first and second magnetic cores (511, 514) is varied, the magnetic flux induced by the first and second winding coils causes the number of magnetic flux concentrated to the first and second magnetic cores to be increased or decreased and thereby inductance caused by the first and second winding coils is varied.

6. The multi-chamber plasma process system according to claim 5, wherein the first and second hollow tubes (518, 519) are formed of an insulator

7. The multi-chamber plasma process system according to any of claims 1 to 3, wherein
the ignition power supply (600) includes a variable transformer (610) that is connected to the power supply on a primary side thereof and connected in parallel to the ignition electrodes of the inductively coupled plasma generators on a secondary side;
the variable transformer includes first and second magnetic cores (601, 605) that take a horseshoe shape and have both ends disposed opposite to each other, a first winding coil (602) wound around the first magnetic core; a second winding coil (606) wound around the second magnetic core, and a driving means (609) arranged to move the first and/or second magnetic cores based on control of the controller to vary a relative position between the first and second magnetic cores; and
in the variable transformer, as the relative position between the first and second magnetic cores (601, 605) is varied, magnetic flux induced by the first and second winding coils has an aligned or deflected direction or an inverse direction and thereby inductance caused by the first and second winding coils is varied; or as the relative distance between the first and second magnetic cores is varied, the magnetic flux induced by the first and second winding coils causes the number of magnetic flux concentrated in common to the first and second magnetic cores to be increased or decreased and thereby induced electromotive force transmitted from the primary winding coil to the secondary winding coil is varied.

8. The mufti-chamber plasma process system according to any preceding claim, wherein
the plurality of process chambers each have at least two holes (909) on a ceiling of a chamber housing in which a susceptor is disposed, the susceptor having a subtracted to be processed rested thereon;
the inductively coupled plasma generator includes
at least one external discharge bridge (901) of a hollow C shape having one side coupled to the at least two holes,
at least one donut-like magnetic core (905) mounted to the external discharge bridge, and
an induction coil (906) wound around the magnetic core and connected to the main power supply through the first impedance matcher,
the induction coil induces electromotive force to form a plasma discharge path inside the external discharge bridge and inside the chamber housing.

9. The multi-chamber plasma process system according to claim 8, wherein the external discharge bridge and the chamber housing have an insulator layer formed on inner surfaces thereof on the whole.

10. The multi-chamber plasma process system according to claim 8 or 9, wherein
each inductively coupled plasma generator includes a plasma density regulator (102, 112, 122);
the plasma density regulator includes a density regulation flat plate (1000) mounted across an inner upper discharge space of the external discharge bridge (901) and formed with holes on the whole; and a driving means arranged to move the density regulation flat plate up and down; and
the plasma density regulator is arranged to increase the plasma density as the density regulation flat plate (1000) moves upward, and to decrease the plasma density as the density regulation flat plate moves (1000) downward.

11. The multi-chamber plasma process system according to any of claims 1 to 7, wherein
the plurality of process chambers each have a plurality of holes (929) on a ceiling of a chamber housing in which a susceptor (907) is disposed, the susceptor having a substrate to be processed rested thereon; and
the inductively coupled plasma generator includes:
a hollow discharge tube head (921) having a plurality of holes on a lower surface thereof to correspond to the plurality of holes formed on the ceiling of the chamber housing and having a gas inlet on an upper surface thereof;
a plurality of hollow discharge tube bridges (931) each connected between the plurality of holes formed on the ceiling of the chamber housing and the plurality of holes formed on the lower surface of the hollow discharge tube head and corresponding to the plurality of holes formed on the ceiling;
a donut-like magnetic core (925) mounted to the hollow discharge tube bridges; and
an induction coil (926) wound around the magnet core and connected to the main power supply through the first impedance matcher,
wherein the induction coil is arranged to induce electromotive force to form a plasma discharge path connecting insides of the hollow discharge tube head, the plurality of hollow discharge bridges and the chamber housing.

12. The multi-chamber plasma process system according to claim 11, wherein the magnetic core (925) is not mounted to at least one of the plurality of hollow discharge bridges.

13. The multi-chamber plasma process system according to claim 11 or 12, wherein the hollow discharge tube head (921), the plurality of hollow discharge bridges (931) and the chamber housing (924) have an insulator layer formed on inner surfaces thereof on the whole.

14. The multi-chamber plasma process system according to claim 11, 12 or 13, wherein
the inductively coupled plasma generator includes a plasma density regulator;
the plasma density regulator includes a density regulation flat plate (1000) mounted across an inner discharge space of the hollow discharge tube head (921) and formed with holes on the whole; and a driving means arranged to move the density regulation flat plate up and down; and
the plasma density regulator is arranged to increase the plasma density as the density regulation flat plate (1000) moves upward, and to decrease the plasma density as the density regulation flat plate moves downward.

15. The multi-chamber plasma process system according to any of claims 1 to 7, wherein
the plurality of process chambers each have an inductively coupled plasma generator disposed in an inner upper space of a chamber housing (944) in which a susceptor (927) is disposed; and
the inductively coupled plasma generator includes
an annular hollow core jacket (951) positioned on the upper space of the chamber housing,
at least one fixing bridge (952) extending from an upper sidewall of the chamber housing to the hollow core jacket so as to fix the hollow core jacket in the upper space of the chamber housing,
an annular magnetic core (945) mounted in the hollow core jacket, and
an induction coil (946) wounded around the annular magnetic core,
wherein the induction coil (946) is arranged to induce electromotive force to form a plasma discharge path surrounding outside of the hollow core jacket on the whole.

16. The mutti-chamber plasma process system according to claim 15, wherein the hollow core jacket (951) and the fixing bridge are formed of an insulator, and the chamber housing has an insulator layer formed on an inner surface thereof on the whole.

17. The multi-chamber plasma process system according to claim 15, wherein
the inductively coupled plasma generator includes a plasma density regulator;
the plasma density regulator includes a density regulation flat plate (1000) mounted across an inner upper space of the chamber housing over the hollow core jacket on the whole; and a driving means arranged to move the density regulation flat plate up and down; and
the plasma density regulator is arranged to increase the plasma density as the density regulation flat plate (1000) moves upward, and to decrease the plasma density as the density regulation flat plate moves downward.

## Patentansprüche

1. Mehrkammerplasmaprozesssystem umfassend:
eine Mehrzahl von Prozesskammern (100, 110, 120), wobei jede einen induktiv gekoppelten Plasmagenerator (101, 111, 121 aufweist,
eine Netzenergieversorgung (400), die dazu ausgebildet ist, dass sie Hochfrequenz(RF)-Energie zum Erzeugen von Plasma zu mindestens einem der induktiv gekoppelten Plasmageneratoren zuführt,
einen ersten Impedanzabgleicher (500), der zwischen die Netzenergieversorgung und den mindestens einen induktiv gekoppelten Plasmagenerator eingeschleift ist,
eine Mehrzahl von Vorspannungsenergiequellen (320), die dazu ausgebildet sind, dass sie Vorspannungsenergie zu einem Suszeptor (103, 113, 123) zuführen, der bei jeder der Mehrzahl von Prozesskammern vorgesehen ist,
**gekennzeichnet durch** eine Zündenergieversorgung (600), der die RF-Energie von der Netzenergieversorgung zugeführt wird und die dazu ausgebildet ist, dass sie Zündenergie zu einer Zündelektrode (104, 114, 124) zuführt, die bei jedem der induktiv gekoppelten Plasmageneratoren (101, 111, 121) vorgesehen ist,
eine Mehrzahl von zweiten Impedanzabgleichern (200, 210, 220), die zwischen die Suszeptoren (103, 113, 123), die bei der Mehrzahl von Prozesskammern vorgesehen sind, und die Vorspannungsenergiequellen, die den Suszeptoren zugeordnet sind, eingeschleift sind, und
eine Steuereinheit (700), die dazu ausgebildet ist, dass sie den ersten Impedanzabgleicher, die Mehrzahl von zweiten Impedanzabgleichern und die Zündenergieversorgung ansteuert,
wobei die Netzenergieversorgung dazu ausgebildet ist, dass sie Hochfrequenzenergie zum Erzeugen von Plasma zu jedem der induktiv gekoppelten Plasmageneratoren in der Mehrzahl von Prozesskammern durch den ersten Impedanzabgleicher zuführt.

2. Mehrkammerplasmaprozesssystem nach Anspruch 1, wobei die bei der Mehrzahl von Prozesskammern vorgesehenen induktiv gekoppelten Plasmageneratoren (101, 111, 121) durch den ersten Impedanzabgleicher (500) mit der Netzenergieversorgung in Reihe elektrisch verbunden sind und die bei den induktiv gekoppelten Plasmageneratoren vorgesehenen Zündelektroden (104, 114, 124) mit der Zündenergieversorgung parallel verbunden sind.

3. Mehrkammerplasmaprozesssystem nach Anspruch 1 oder 2, wobei die Mehrzahl von Prozesskammern (100, 110, 120) eine Stapelstruktur aufweisen, wobei mindestens zwei Prozesskammern oder eine Clusterstruktur gestapelt sind.

4. Mehrkammerplasmaprozesssystem nach einem der vorhergehenden Ansprüche, wobei
der erste Impedanzabgleicher (500) und die Mehrzahl von zweiten Impedanzabgleichern (200, 210, 220) jeweils mindestens einen variablen Induktor zum Impedanzabgleich aufweisen,
der variable Induktor einen ersten und einen zweiten Magnetkern (511, 514), die eine Hufeisenform annehmen und bei denen beide Enden einander gegenüberliegend angeordnet sind, erste und zweite Wicklungsspulen (512, 515), die um den ersten bzw. zweiten Magnetkern gewickelt sind, und ein Treibermittel (517) aufweist, das dazu ausgebildet ist, dass es den ersten und/oder zweiten Magnetkern in Abhängigkeit von einer Ansteuerung der Steuereinheit so bewegt, dass eine relative Position zwischen dem ersten und zweiten Magnetkern verändert wird, und im variablen Induktor, wenn die relative Position zwischen dem ersten und zweiten Magnetkern (511, 514) verändert wird, der von der ersten und zweiten Wicklungsspule induzierte Magnetfluss eine ausgerichtete oder abgelenkte Richtung oder eine umgekehrte Richtung aufweist, und **dadurch** eine von der ersten und zweiten Wicklungsspule ausgelöste Induktanz verändert wird, oder, wenn der relative Abstand zwischen dem ersten und zweiten Magnetkern verändert wird, führt der von der ersten und zweiten Wicklungsspule induzierte Magnetfluss dazu, dass die Anzahl von Magnetflüssen, die am ersten und zweiten Magnetkern konzentriert sind, erhöht oder verringert wird, und **dadurch** die von der ersten und zweiten Wicklungsspule ausgelöste Induktanz verändert wird.

5. Mehrkammerplasmaprozesssystem nach einem der Ansprüche 1 bis 3, wobei
der erste Impedanzabgleicher (500) und die Mehrzahl von zweiten lmpedanzabgleichern (200, 210, 220) jeweils mindestens einen variablen Induktor zum Impedanzabgleich aufweisen,
der variable Induktor ein erstes und ein zweites Hohlrohr (518, 519), bei denen beide Enden geöffnet und parallel angeordnet sind, erste und zweite kontinuierliche Wicklungsspulen, die um den ersten bzw. zweiten Magnetkern (511, 514) gewickelt sind, erste und zweite Magnetkerne, die am ersten und zweiten Hohlrohr angebracht sind, eine Hufeisenform annehmen und bei denen beide Enden einander gegenüberliegend angeordnet sind, und ein Treibermittel (517) aufweist, das dazu ausgebildet ist, dass es den ersten und/oder zweiten Magnetkern in Abhängigkeit von einer Ansteuerung der Steuereinheit so bewegt, dass ein relativer Abstand zwischen dem ersten und zweiten Magnetkern verändert wird, und
im variablen Induktor, wenn der relative Abstand zwischen dem ersten und zweiten Magnetkern (511, 514) verändert wird, der von der ersten und zweiten Wicklungsspule induzierte Magnetfluss dazu führt, dass die Anzahl von Magnetflüssen, die am ersten und zweiten Magnetkern konzentriert sind, erhöht oder verringert wird, und **dadurch** eine von der ersten und zweiten Wicklungsspule ausgelöste Induktanz verändert wird.

6. Mehrkammerplasmaprozesssystem nach Anspruch 5, wobei das erste und zweite Hohlrohr (518, 519) aus einem Isolator gebildet sind.

7. Mehrkammerplasmaprozesssystem nach einem der Ansprüche 1 bis 3, wobei
die Zündenergieversorgung (600) einen variablen Transformator (610) aufweist, der auf einer ersten Seite mit der Energieversorgung verbunden ist und auf einer zweiten Seite mit den Zündelektroden der induktiv gekoppelten Plasmageneratoren parallel verbunden ist,
der variable Transformator einen ersten und einen zweiten Magnetkern (601, 605), die eine Hufeisenform annehmen und bei denen beide Enden einander gegenüberliegend angeordnet sind, eine erste Wicktungsspule (602), die um den ersten Magnetkern gewickelt ist, eine zweite Wicklungsspule (606), die um den zweiten Magnetkern gewickelt ist, und ein Treibermittel (609) aufweist, das dazu ausgebildet ist, dass es den ersten und/oder zweiten Magnetkern in Abhängigkeit von einer Ansteuerung der Steuereinheit so bewegt, dass eine relative Position zwischen dem ersten und zweiten Magnetkern verändert wird, und
beim variablen Transformator, wenn die relative Position zwischen dem ersten und zweiten Magnetkern (601, 605) verändert wird, der von der ersten und zweiten Wicklungsspule induzierte Magnetfluss eine ausgerichtete oder abgelenkte Richtung oder eine umgekehrte Richtung aufweist, und **dadurch** eine von der ersten und zweiten Wicklungsspule ausgelöste Induktion verändert wird, oder, wenn der relative Abstand zwischen dem ersten und zweiten Magnetkern verändert wird, der von der ersten und zweiten Wicklungsspule induzierte Magnetfluss dazu führt, dass die Anzahl von Magnetflüssen, die am ersten und zweiten Magnetkern gemeinsam konzentriert sind, erhöht oder verringert wird, und **dadurch** eine von der ersten Wicklungsspule zur zweiten Wicklungsspule übertragene induzierte elektromotorische Kraft verändert wird.

8. Mehrkammerplasmaprozesssystem nach einem der vorhergehenden Ansprüche, wobei
die Mehrzahl von Prozesskammern jeweils mindestens zwei Öffnungen (909) an einer Decke eines Kammergehäuses aufweisen, worin ein Suszeptor angeordnet ist, wobei der Suszeptor ein zu verarbeitendes Substrat darauf gesetzt trägt,
ein induktiv gekoppelter Plasmagenerator umfasst:
mindestens eine externe Entladungsbrücke (901) in Form eines hohlen C, wobei eine Seite mit den mindestens zwei Öffnungen gekoppelt ist,
mindestens einen kringelförmigen Magnetkern (905), der an der externen Entladungsbrücke angebracht ist, und
eine Induktionsspule (906), die um den Magnetkern gewickelt und mit der Netzenergieversorgung durch einen ersten Impedanzabgleicher verbunden ist,
die Induktionsspule eine elektromotorische Kraft induziert, so dass ein Plasmaentladungsweg in der externen Entladungsbrücke und in dem Kammergehäuse gebildet wird.

9. Mehrkammerplasmaprozesssystem nach Anspruch 8, wobei die externe Entladungsbrücke und das Kammergehäuse insgesamt eine Isolatorschicht auf ihren Innenflächen ausgebildet aufweisen.

10. Mehrkammerplasmaprozesssystem nach Anspruch 8 oder 9, wobei
jeder induktiv gekoppelte Plasmagenerator einen Plasmadichteregler (102, 112, 122) aufweist,
der Plasmadichteregler eine Dichteregulierungsplatte (1000) aufweist, die insgesamt quer durch einen inneren oberen Entladungsraum der externen Entladungsbrücke (901) angebracht und mit Öffnungen ausgebildet ist, und ein Treibermittel dazu ausgebildet ist, dass es die Dichteregulierungsplatte auf- und abbewegt, und
der Plasmadichteregler dazu ausgebildet ist, dass er die Plasmadichte erhöht, wenn die Dichteregulierungsplatte (1000) sich nach oben bewegt, und die Plasmadichte senkt, wenn die Dichteregulierungsplatte (1000) sich nach unten bewegt.

11. Mehrkammerplasmaprozesssystem nach einem der Ansprüche 1 bis 7, wobei
die Mehrzahl von Prozesskammern jeweils eine Mehrzahl von Öffnungen (929) an einer Decke eines Kammergehäuses aufweisen, worin ein Suszeptor (907) angeordnet ist, wobei der Suszeptor ein zu verarbeitendes Substrat darauf gesetzt trägt, und
der induktiv gekoppelte Plasmagenerator umfasst:
einen hohlen Entladungsrohrkopf (921) mit einer Mehrzahl von Öffnungen auf seiner Unterseite, die der Mehrzahl von Öffnungen zugeordnet sind, die an der Decke des Kammergehäuses ausgebildet sind, und mit einem Gaseinlass an seiner Oberseite,
eine Mehrzahl von hohlen Entladungsrohrbrücken (931), die jeweils zwischen der Mehrzahl von Öffnungen, die an der Decke des Kammergehäuses ausgebildet sind, und der Mehrzahl von Öffnungen, die an der Unterseite des hohlen Entladungsrohrkopfes ausgebildet sind, eingeschleift und der Mehrzahl von Öffnungen zugeordnet sind, die an der Decke ausgebildet sind,
einen kringelförmigen Magnetkern (925), der an den hohlen Entladungsrohrbrücken angebracht sind, und
eine Induktionsspule (926), die um den Magnetkern gewickelt und mit der Netzenergieversorgung durch den ersten Impedanzabgleicher verbunden ist,
wobei die Induktionsspule dazu ausgebildet ist, dass sie eine elektromotorische Kraft induziert, so dass ein Plasmaentladungsweg gebildet wird, der das Innere des hohlen Entladungsrohrkopfes, die Mehrzahl von hohlen Entladungsbrücken und das Kammergehäuse verbindet.

12. Mehrkammerplasmaprozesssystem nach Anspruch 11, wobei der Magnetkern (925) nicht an mindestens einer der Mehrzahl von hohlen Entladungsbrücken angebracht ist.

13. Mehrkammerplasmaprozesssystem nach Anspruch 11 oder 12, wobei der hohle Entladungsrohrkopf (921), die Mehrzahl von hohlen Entladungsbrücken (931) und das Kammergehäuse (924) insgesamt auf ihren Innenflächen eine Isolierschicht ausgebildet aufweisen.

14. Mehrkammerplasmaprozesssystem nach Anspruch 11, 12 oder 13, wobei
der induktiv gekoppelte Plasmagenerator einen Plasmadichteregler aufweist,
der Plasmadichteregler eine Dichteregulierungsplatte (1000) aufweist, die insgesamt quer durch einen inneren Entladungsraum des hohlen Entladungsrohrkopfs (921) angebracht und mit Öffnungen ausgebildet ist, und ein Treibermittel dazu ausgebildet ist, dass es die Dichteregulierungsplatte auf- und abbewegt, und
der Plasmadichteregler dazu ausgebildet ist, dass er die Plasmadichte erhöht, wenn die Dichteregulierungsplatte (1000) sich nach oben bewegt, und die Plasmadichte senkt, wenn die Dichteregulierungsplatte sich nach unten bewegt.

15. Mehrkammerplasmaprozesssystem nach einem der Ansprüche 1 bis 7, wobei
die Mehrzahl von Prozesskammern jeweils einen induktiv gekoppelten Plasmagenerator in einem inneren oberen Raum eines Kammergehäuses (944) angeordnet aufweisen, worin ein Suszeptor (927) angeordnet ist, und
der induktiv gekoppelte Plasmagenerator umfasst:
eine ringförmige hohle Kernummantelung (951), die am oberen Raum des Kammergehäuses positioniert ist,
mindestens eine Befestigungsbrücke (952), die sich von einer oberen Seitenwand des Kammergehäuses zu der hohlen Kernummantelung so erstreckt, dass die hohle Kernummantelung im oberen Raum des Kammergehäuses befestigt ist,
einen ringförmigen Magnetkern (945), der in der hohlen Kernummantelung angebracht ist, und
eine Induktionsspule (946), die um den ringförmigen Magnetkern gewickelt ist,
wobei die Induktionsspule (946) dazu ausgebildet ist, dass sie eine elektromotorische Kraft induziert, so dass ein Plasmaentladungsweg gebildet wird, der insgesamt die Außenseite der hohlen Kernummantelung umgibt.

16. Mehrkammerplasmaprozesssystem nach Anspruch 15, wobei die hohle Kernummantelung (951) und die Befestigungsbrücke aus einem Isolator gebildet sind und das Kammergehäuse insgesamt eine Isolatorschicht auf ihrer Innenfläche ausgebildet aufweist.

17. Mehrkammerplasmaprozesssystem nach Anspruch 15, wobei der induktiv gekoppelte Plasmagenerator einen Plasmadichteregler aufweist,
der Plasmadichteregler eine Dichteregulierungsplatte (1000) aufweist, die insgesamt quer durch einen inneren oberen Raum des Kammergehäuses über die hohle Kernummantelung angebracht ist, und ein Treibermittel dazu ausgebildet ist, dass es die Dichteregulierungsplatte auf- und abbewegt, und
der Plasmadichteregler dazu ausgebildet ist, dass er die Plasmadichte erhöht, wenn die Dichteregulierungsplatte (1000) sich nach oben bewegt, und die Plasmadichte senkt, wenn die Dichteregulierungsplatte sich nach unten bewegt.

## Revendications

1. Système de traitement au plasma à chambres multiples comprenant :
une pluralité de chambres de traitement (100, 110, 120) ayant chacune un générateur de plasma couplé inductivement (101, 111, 121) ;
une alimentation électrique principale (400) agencée pour fournir à au moins l'un desdits générateurs de plasma couplés inductivement une puissance de fréquence radioélectrique (RF) pour générer un Plasma;
un premier adaptateur d'impédance (500) connecté entre l'alimentation électrique principale et l'au moins un générateur de plasma couplé inductivement ;
une pluralité de sources de puissance de polarisation (320) agencée pour fournir une puissance de polarisation à un suscepteur (103, 113, 123) équipant chacune de la pluralité de chambres de traitement;
**caractérisé par** une alimentation électrique d'allumage (600) fournie avec la puissance RF provenant de l'alimentation électrique principale et agencée pour fournir une puissance d'allumage à une électrode d'allumage (104, 114, 124) équipant chaque générateur de plasma couplé inductivement (101, 111, 121);
une pluralité de seconds adaptateurs d'impédance (200, 210, 220) connectés entre les suscepteurs (103, 113, 123) équipant la pluralité de chambres de traitement et les sources de puissance de polarisation correspondant aux suscepteurs ; et
une unité de commande (700) agencée pour commander le premier adaptateur d'impédance, la pluralité de seconds adaptateurs d'impédance et l'alimentation électrique d'allumage ;
dans lequel l'alimentation électrique principale est agencée pour fournir une puissance de fréquence radioélectrique pour générer un plasma à chacun des générateurs de plasma couplés inductivement dans la pluralité de chambres de traitement par le biais du premier adaptateur d'impédance.

2. Système de traitement au plasma à chambres multiples selon la revendication 1, dans lequel les générateurs de plasma couplés inductivement (101, 111, 121) équipant la pluralité de chambres de traitement sont connectés électriquement en série à l'alimentation électrique principale par le biais du premier adaptateur d'impédance (500), et les électrodes d'allumage (104, 114, 124) équipant les générateurs de plasma couplés inductivement sont connectées en parallèle à l'alimentation électrique d'allumage.

3. Système de traitement au plasma à chambres multiples selon la revendication 1 ou 2, dans lequel la pluralité de chambres de traitement (100, 110, 120) a une structure empilée à raison d'au moins deux chambres de traitement ou une structure de grappe.

4. Système de traitement au plasma à chambres multiples selon l'une quelconque des revendications précédentes, dans lequel
le premier adaptateur d'impédance (500) et la pluralité de seconds adaptateurs d'impédance (200, 210, 220) comportent chacun au moins une bobine d'induction variable pour l'adaptation d'impédance ;
la bobine d'induction variable comporte des premier et second noyaux magnétiques (511, 514) qui ont la forme d'un fer à cheval et dont les deux extrémités sont disposées en opposition l'une à l'autre, des premier et second bobinages (512, 515) enroulés autour des premier et second noyaux magnétiques respectivement, et un moyen d'entraînement (517) agencé pour déplacer les premier et/ou second noyaux magnétiques en fonction de la commande de l'unité de commande pour faire varier une position relative entre les premier et second noyaux magnétiques ; et
dans la bobine d'induction variable, quand la position relative entre les premier et second noyaux magnétiques (511, 514) varie, le flux magnétique induit par les premier et second bobinages a un sens aligné ou dévié ou un sens inverse entraînant alors une variation de l'inductance causée par les premier et second bobinages ; ou quand la distance relative entre les premier et second noyaux magnétiques varie, le flux magnétique induit par les premier et second bobinages entraîne une augmentation ou une réduction du nombre de flux magnétiques concentrés sur les premier et second noyaux magnétiques et ainsi une variation de l'inductance causée par les premier et second bobinages.

5. Système de traitement au plasma à chambres multiples selon l'une quelconque des revendications 1 à 3, dans lequel
le premier adaptateur d'impédance (500) et la pluralité de seconds adaptateurs d'impédance (200, 210, 220) comportent chacun au moins une bobine d'induction variable pour l'adaptation d'impédance;
la bobine d'induction variable comporte des premier et second tubes creux (518, 519) dont les deux extrémités sont ouvertes et disposées en parallèle, des premier et second bobinages continus enroulés autour des premier et second noyaux magnétiques (511, 514) respectivement, des premier et second noyaux magnétiques qui sont montés sur les premier et second tubes creux, ont une forme de fer à cheval et dont les deux extrémités sont disposées en opposition l'une à l'autre, et un moyen d'entraînement (517) agencé pour déplacer les premier et/ou second noyaux magnétiques en fonction de la commande de l'unité de commande pour faire varier une position relative entre les premier et second noyaux magnétiques; et
dans la bobine d'induction variable, quand la distance relative entre les premier et second noyaux magnétiques (511, 514) varie, le flux magnétique induit par les premier et second bobinages entraîne une augmentation ou une réduction du nombre de flux magnétiques concentrés sur les premier et second noyaux magnétiques et ainsi une variation de l'inductance causée par les premier et second bobinages.

6. Système de traitement au plasma à chambres multiples selon la revendication 5, dans lequel les premier et second tubes creux (518, 519) sont formés d'un isolant.

7. Système de traitement au plasma à chambres multiples selon l'une quelconque des revendications précédentes 1 à 3, dans lequel
l'alimentation électrique d'allumage (600) comporte un transformateur variable (610) qui est connecté à l'alimentation électrique sur un primaire de celui-ci et connecté en parallèle aux électrodes d'allumage des générateurs de plasma couplés inductivement sur un secondaire;
le transformateur variable comporte des premier et second noyaux magnétiques (601, 605) qui ont la forme d'un fer à cheval et dont les deux extrémités sont disposées en opposition l'une à l'autre, un premier bobinage (602) enroulé autour du premier noyau magnétique ; un second bobinage (606) enroulé autour du second noyau magnétique, et un moyen d'entraînement (609) agencé pour déplacer les premier et/ou second noyaux magnétiques en fonction de la commande de l'unité de commande pour faire varier une position relative entre les premier et second noyaux magnétiques ; et
dans le transformateur variable, quand la position relative entre les premier et second noyaux magnétiques (601, 605) varie, le flux magnétique induit par les premier et second bobinages a un sens aligné ou dévié ou un sens inverse entraînant ainsi une variation de l'inductance causée par les premier et second bobinages ; ou quand la distance relative entre les premier et second noyaux magnétiques varie, le flux magnétique induit par les premier et second bobinages entraîne une augmentation ou une réduction du nombre de flux magnétiques concentrés en commun sur les premier et second noyaux magnétiques et ainsi une variation de la force électromotrice induite transmise par le bobinage primaire au bobinage secondaire.

8. Système de traitement au plasma à chambres multiples selon l'une quelconque des revendications précédentes, dans lequel
les chambres de la pluralité de chambres de traitement ont chacune au moins deux trous (909) sur un plafond d'une enceinte de chambre dans laquelle un suscepteur est disposé, un substrat à traiter reposant sur le suscepteur ;
le générateur de plasma couplé inductivement comporte
au moins un pont de décharge externe (901) d'une forme en C creuse dont un côté est couplé aux au moins deux trous,
au moins un noyau magnétique en forme de chambre torique (905) monté sur le pont de décharge externe, et
une bobine d'induction (906) enroulée autour du noyau magnétique et connectée à l'alimentation électrique principale par le biais du premier adaptateur d'impédance ;
la bobine d'induction induit une force électromotrice pour former un trajet de décharge de plasma à l'intérieur du pont de décharge externe et à l'intérieur de l'enceinte de chambre.

9. Système de traitement au plasma à chambres multiples selon la revendication 8, dans lequel le pont de décharge externe et l'enceinte de chambre ont une couche isolante formée sur leurs surfaces internes sur leur totalité.

10. Système de traitement au plasma à chambres multiples selon la revendication 8 ou 9, dans lequel
chaque générateur de plasma couplé inductivement comporte un régulateur de densité de plasma (102, 112, 122) ;
le régulateur de densité de plasma comporte une plaque plate de régulation de densité (1000) montée en travers d'un espace de décharge supérieur interne du pont de décharge externe (901) et ayant des trous sur sa totalité ; et un moyen d'entraînement agencé pour déplacer vers le haut et vers le bas la plaque plate de régulation de densité ; et
le régulateur de densité de plasma est agencé pour augmenter la densité de plasma quand la plaque plate de régulation de densité (1000) monte, et diminuer la densité du plasma quand la plaque plate de régulation de densité (1000) descend.

11. Système de traitement au plasma à chambres multiples selon l'une quelconque des revendications 1 à 7, dans lequel
les chambres de la pluralité de chambres de traitement ont chacune une pluralité de trous (929) sur un plafond d'une enceinte de chambre dans laquelle un suscepteur (907) est disposé, un substrat à traiter reposant sur le suscepteur ; et
le générateur de plasma couplé inductivement comporte
une tête de tube de décharge creux (921) ayant une pluralité de trous sur une surface inférieure de celle-ci destinée à correspondre à la pluralité de trous formés sur le plafond de l'enceinte de chambre et ayant une admission de gaz sur une surface supérieure de celle-ci;
une pluralité de ponts de tube de décharge creux (931) connectés chacun entre la pluralité de trous formés sur le plafond de l'enceinte de chambre et la pluralité de trous formés sur la surface inférieure de la tête de tube de décharge creux et correspondant à la pluralité de trous formés sur le plafond ;
un noyau magnétique en forme de chambre torique (925) monté sur les ponts de tube de décharge creux ; et
une bobine d'induction (926) enroulée autour du noyau magnétique et connectée à l'alimentation électrique principale par le biais du premier adaptateur d'impédance ;
dans lequel la bobine d'induction est agencée pour induire une force électromotrice afin de former un trajet de décharge de plasma connectant des parties intérieures de la tête de tube de décharge creux, la pluralité de ponts de décharge creux et l'enceinte de chambre,

12. Système de traitement au plasma à chambres multiples selon la revendication 11, dans lequel le noyau magnétique (925) n'est pas monté sur au moins l'un de la pluralité de ponts de décharge creux.

13. Système de traitement au plasma à chambres multiples selon la revendication 11 ou 12, dans lequel la tête de tube de décharge creux (921), la pluralité de ponts de décharge creux (931) et l'enceinte de chambre (924) ont une couche isolante formée sur des surfaces internes de ceux-ci sur leur totalité.

14. Système de traitement au plasma à chambres multiples selon la revendication 11, 12 ou 13, dans lequel
le générateur de plasma couplé inductivement comporte un régulateur de densité de plasma ;
le régulateur de densité de plasma comporte une plaque plate de régulation de densité (1000) montée en travers d'un espace de décharge supérieur interne de la tête de tube de décharge creux (921) et ayant des trous sur sa totalité ; et un moyen d'entraînement agencé pour déplacer vers le haut et vers le bas la plaque plate de régulation de densité ; et
le régulateur de densité de plasma est agencé pour augmenter la densité du plasma quand la plaque plate de régulation de densité (1000) monte, et diminuer la densité du plasma quand la plaque plate de régulation de densité descend.

15. Système de traitement au plasma à chambres multiples selon l'une quelconque des revendications précédentes 1 à 7, dans lequel
les chambres de la pluralité de chambres de traitement ont chacune un générateur de plasma couplé inductivement disposé dans un espace intérieur supérieur d'une enceinte de chambre (944) dans lequel est disposé un suscepteur (927) ; et
le générateur de plasma couplé inductivement comporte
une chemise de noyau creuse annulaire (951) positionnée sur l'espace supérieur de l'enceinte de chambre,
au moins un pont de fixation (952) s'étendant depuis une paroi latérale supérieure de l'enceinte de chambre jusqu'à la chemise de noyau creuse de façon à fixer la chemise de noyau creuse dans l'espace supérieur de l'enceinte de chambre,
un noyau magnétique annulaire (945) monté dans la chemise de noyau creuse, et
une bobine d'induction (946) enroulée autour du noyau magnétique annulaire,
dans lequel la bobine d'induction (946) est agencée pour induire une force électromotrice afin de former un trajet de décharge de plasma entourant la totalité de l'extérieur de la chemise de noyau creuse.

16. Système de traitement au plasma à chambres multiples selon la revendication 15, dans lequel la chemise de noyau creuse (951) et le pont de fixation sont formés d'un isolant, et l'enceinte de chambre a une couche isolante formée sur une surface interne de celle-ci sur sa totalité.

17. Système de traitement au plasma à chambres multiples selon la revendication 15, dans lequel
le générateur de plasma couplé inductivement comporte un régulateur de densité de plasma;
le régulateur de densité de plasma comporte une plaque plate de régulation de densité (1000) montée en travers d'un espace de décharge supérieur interne de l'enceinte de chambre par-dessus la totalité de la chemise de noyau creuse, et un moyen d'entraînement agencé pour déplacer vers le haut et vers le bas la plaque plate de régulation de densité; et
le régulateur de densité de plasma est agencé pour augmenter la densité du plasma quand la plaque plate de régulation de densité (1000) monte, et diminuer la densité du plasma quand la plaque plate de régulation de densité descend.
